# EUROPÄISCHE PATENTANMELDUNG

(11) **EP 0 869 559 A2**
(43) Veröffentlichungstag der Anmeldung: **07.10.1998**
(21) Anmeldenummer: 98106092.4
(22) Anmeldetag: 02.04.1998
(51) Int. Cl.: H01L 29/864, H01L 29/868, H01L 29/06

(54) **Power diode**

(30) Priorität: 04.04.1997 DE 19713980
(71) Anmelder: SIEMENS AKTIENGESELLSCHAFT, 80333 München (DE)
(72) Erfinder: Sittig, Roland, 38104 Braunschweig (DE); Taghizadeh-Kaschani, Karim-Thomas, 82008 Unterhaching (DE)

(57) **Zusammenfassung**

Die Erfindung betrifft eine pin-Diode, bestehend aus einer Innenzone (2), einer Kathodenzone (3), einer Anodenzone (6). Erfindungsgemäß ist die Grenzfläche (4) zwischen der Innenzone (2) und der Anodenzone (6) zumindest teilweise gekrümmt und/oder in der Innenzone (2) ist zumindest ein floatendes Gebiet (5) vom selben Leitungstyp und höhere Dotierungskonzentration als in der Innenzone (2) vorgesehen. Das Abkommutierverhalten bei derartigen geometrisch gekoppelten Leistungsdioden ist im Gegensatz zum Abkommutierverhalten von pin-Leistungsdioden (in der Ausführung als Read-Diode) mit Raumladungskopplung weitgehend temperaturunabhängig. In einer Weiterbildung lassen sich aus diesen FCI-Dioden Hybrid-Dioden mit optimiertem Durchlaß- und Abkommutierverhalten herstellen. Eine bevorzugte Anwendung finden FCI-Dioden in Verbindung mit schaltenden Leistungshalbleiterbauelementen als Spannungsbegrenzer oder Freilaufdioden.

## Beschreibung

Die Erfindung betrifft eine Leistungsdiode, bestehend aus einem Halbleiterkörper mit
- einer Innenzone vom ersten Leitungstyp,
- einer an die Innenzone anschließenden Kathodenzone vom ersten Leitungstyp und höherer Dotierungskonzentration als inder Innenzone,
- einer an die Innenzone anschließenden Anodezone vom zweiten Leitungstyp und höhere Dotierungskonzentration als in der Innenzone.

Solche Leistungsdioden, die auch pin-Dioden genannt werden, sind seit langer Zeit bekannt und beispielsweise von F. Kaußen und H. Schlangenotto in 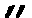 Aktuelle Entwicklungen bei schnellschaltenden Leistungsdioden 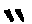 , 39.ETG-Fachbericht, VDE-Verlag, Seite 25 bis 40, Bad Nauheim, 1992, eingehend beschrieben.

Eine FCI-Diode (field-controlled-injection) der eingangs genannten Art ist beispielsweise als Read-Diode bekannt und von K. T. Kaschani und R. Sittig in 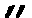 How to avoid TRAPATT-Oszillations at the Revers-Recovery of Power Diodes 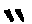 , CAS'95, S. 571 - 574, Sinaia, 1995, beschrieben. Der Gegenstand dieser Druckschrift wird hiermit ausführlich in die vorliegende Anmeldung einbezogen ( 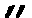 incorporated by reference 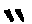 ).

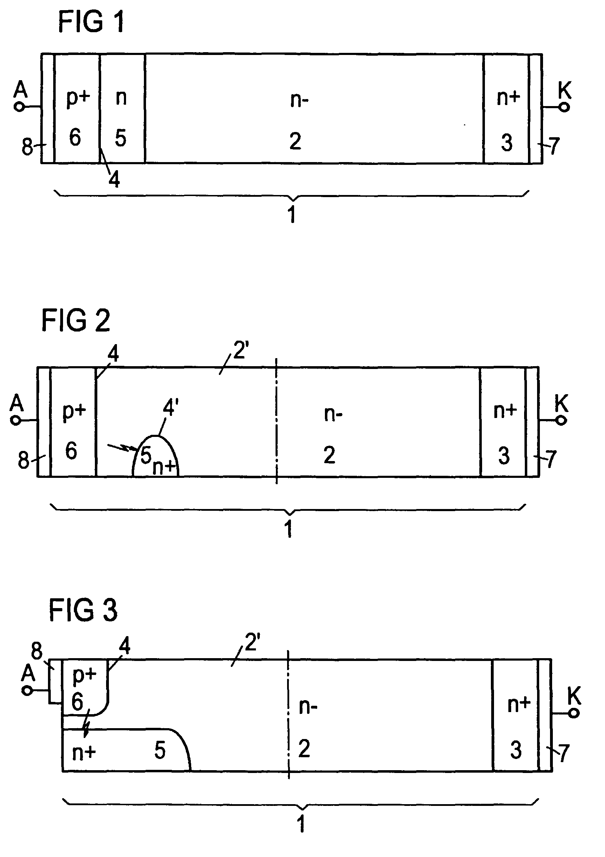

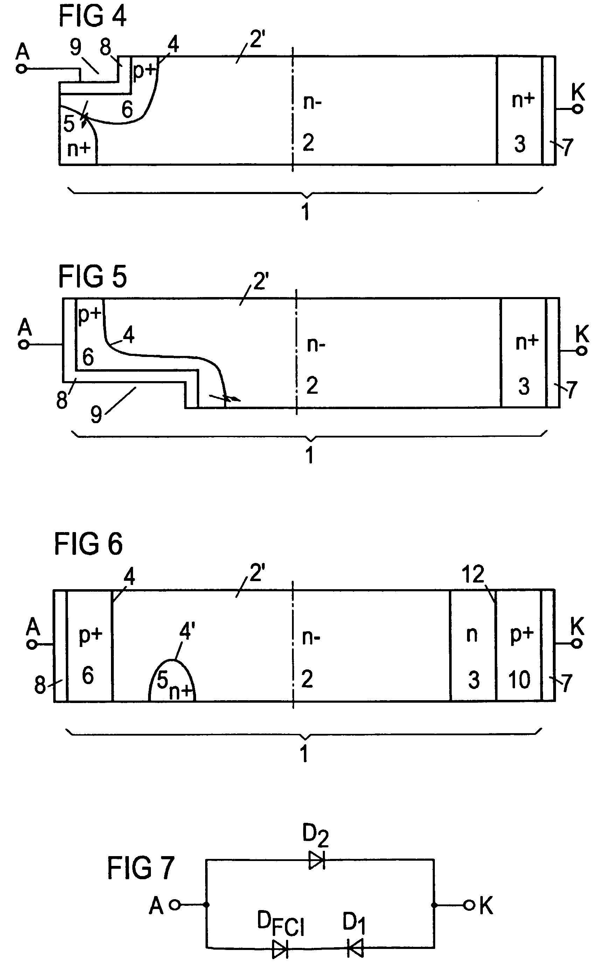

Die Read-Diode ist ursprünglich als Hochfrequenz-Bauelement für die Generierung von IMPATT-Schwingungen entwickelt worden. Im Folgenden wird in Figur 1 das FCI-Konzept anhand der bekannten Read-Diode in der speziellen Ausführung als pin-Leistungsdiode erläutert. Eine derartige Read-Diode ist insbesondere aus Figur 5 der oben erwähnten Druckschrift von Kaschani et al. bekannt.

Die pin-Leistungsdiode entsprechend Figur 1 zeigt einen Halbleiterkörper 1. Der Halbleiterkörper 1 besteht aus einer n 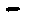 -dotierten Innenzone 2. Kathodenseitig ist an die Innenzone 2 die n 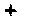 -dotierte Kathodenzone 3 angeordnet. Die Kathodenzone 3 ist über die Kathodenelektrode 7 mit dem Kathodenanschluß K verbunden. Anodenseitig schließt sich an die Innenzone 2 eine n-dotierte Kopplungszone 5 sowie eine p 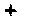 -dotierte Anodenzone 6 an. Anodenseitig ist die Anodenzone 6 über die Anodenelektrode 8 mit dem Anodenanschluß A verbunden.

Wie aus der Figur 1 hervorgeht, ist bei der pin-Diode zwischen die Anodenzone 6 und die Innenzone 2 eine schmale Kopplungszone 5 eingebracht, die denselben Leitungstyp aufweist wie die Innenzone 2, aber stärker dotiert ist als die Innenzone 2. Aufgrund dieses Dotierungsprofils setzt sich das elektrische Feld im Sperrbetrieb aus einer sogenannten Hochfeldzone und einer sogenannten Niederfeldzone zusammen. Mit Hochfeldzone werden dabei Gebiete mit hoher elektrischer Feldstärke und mit Niederfeldzone Gebiete mit niedrigem elektrischen Feld bezeichnet.

Während sich die Hochfeldzone dabei auf den schmalen Bereich der Kopplungszone 5 unmittelbar vor der Anodenzone 6 beschränkt, erstreckt sich die Niederfeldzone nahezu homogen über die gesamte Innenzone 2. Entsprechend der Höhe der Dotierung ergibt sich allerdings auch eine deutlich höhere Durchbruchfeldstärke in der Kochfeldzone als in der Niederfeldzone (E_{BD,H} >> E_{BD,L}).

Um nun eine lokalisierte Lawinenmultiplikation beim Spannungsdurchbruch zu gewährleisten, ist die pin-Diode so dimensioniert, daß die Feldspitze in der Hochfeldzone zu diesem Zeitpunkt gerade ihre Durchbruchfeldstärke E_{BD,H} erreicht, während sich das Feldmaximum in der Niederfeldzone noch weit unterhalb seiner Durchbruchfeldstärke E_{BD,L} befindet. Wird daher die Durchbruchspannung V_{BD} überschritten, so kommt es zunächst nur in der Hochfeldzone zur Ladungsträgergeneration durch Lawinenmultiplikation.

Während die auf diese Weise generierten Löcher sofort an der angrenzenden, p 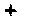 -dotierten Anodenzone 6 abfließen, müssen die Elektronen auf dem Weg zur n 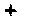 -dotierten Kathodenzone 3 die gesamte Raumladungszone durchqueren. Die Elektronen bewegen sich dabei in der Hochfeldzone mit Sättigungsgeschwindigkeit und führen aufgrund ihrer negativen Ladung zu einer entsprechenden Kompensation der Raumladungen von Hochfeldzone und Niederfeldzone.

Die Wirkung dieser Kompensation auf beide Zonen ist jedoch unterschiedlich. So kommt es in der Hochfeldzone zu einer Verringerung der Feldspitze und zu einer Reduktion der Lawinenmultiplikation, was wiederum zu einer Abnahme des Elektronenstroms beziehungsweise seiner kompensierenden Wirkung auf die dortige Raumladung führt. Diese Gegenkopplung hat schließlich unabhängig von der anliegenden Überspannung eine Stabilisierung des Feldmaximums nahe der Durchbruchfeldstärke E_{BD,H} zur Folge.

Die Hochfeldzone dient daher sowohl zur Bereitstellung der erforderlichen Ladungsträger als auch zur erforderlichen Lokalisierung der Lawinenmultiplikation. In der Niederfeldzone dagegen führt die zunehmende Kompensation der Raumladung durch den mit steigender Überspannung anwachsenden Elektronenstrom zu einer Zunahme des Gradienten des elektrischen Feldes und damit zu einer entsprechenden Erhöhung des elektrischen Feldes, insbesondere vor der Kathodenzone 3.

Die Kopplung der elektrischen Felder von Hochfeldzone und der Niederfeldzone erfolgt bei der pin-Leistungsdiode entsprechend Figur 1 über die Raumladung der Kopplungszone 5. Die Raumladungskopplung hat sich jedoch für das Abkommutieren von Leistungsdioden als schwierig zu handhaben erwiesen, da die Raumladungskopplung in der Regel sehr stark temperaturabhängig ist. Ein Einsatz von derartigen pin-Leistungsdioden in der Praxis ist demnach schwierig.

Aufgabe der vorliegenden Erfindung ist es daher, neue FCI-Dioden bereitzustellen, bei denen die Hochfeldzone mit der Niederfeldzone nahezu temperaturunabhängig gekoppelt ist.

Erfindungsgemäß wird diese Aufgabe durch eine Leistungsdiode der eingangs genannten Art gelöst, die dadurch gekennzeichnet ist, daß die Grenzfläche zwischen der Innenzone und der Anodenzone zumindest teilweise gekrümmt ist und/oder in der Innenzone zumindest ein floatendes Gebiet vom ersten Leitungstyp vorgesehen ist.

In der ersten Ausgestaltung der Erfindung ist die Grenzfläche zwischen der Innenzone und der Anodenzone gekrümmt ausgebildet. Durch diese Maßnahme wird eine scharf lokalisierte Feldüberhöhung bewirkt, was der Einrichtung einer Hochfeldzone und einer Niederfeldzone entspricht, die hier nicht raumladungsgekoppelt und somit auch nicht stark temperaturabhängig sind.

In der zweiten Ausgestaltung der Erfindung befindet sich in der Innenzone zumindest ein bezüglich der Potentiale floatendes Gebiet vom selben Leitungstyp wie in der Innenzone. Durch das Einbringen solcher floatender Gebiete, die typischerweise sehr viel stärker dotiert sind als die Innenzone selbst, werden Äquipotentialzonen in der Innenzone eingerichtet, die eine Störung des elektrischen Feldes und somit in gewissen Bereichen eine scharf lokalisierte Feldüberhöhung bewirken. Diese scharf lokalisierte Feldüberhöhung bewirkt wiederum das Einrichten einer lokalen Hochfeldzone und einer Niederfeldzone, die hier ebenfalls nicht raumladungsgekoppelt sind und somit auch nicht einer starken Temperaturabhängigkeit unterliegen.

Derartige Leistungsdioden werden im folgenden als FCI-Dioden mit geometrischer Kopplung bezeichnet.

Pin-Leistungsdioden mit geometrischer Kopplung haben gegenüber pin-Leistungsdioden mit Raumladungskopplung den Vorteil, daß der Abkommutiervorgang weitgehend temperaturunabhängig abläuft.

Außerdem weisen geometrisch gekoppelte FCI-Dioden im Gegensatz zu den herkömmlichen pin-Dioden eine aktive, kontrollierte Überspannungsbegrenzung auf, die weitgehend unabhängig von Speicherladung, Abkommutiergeschwindigkeit und Lebensdauereinstellung ist, zu keiner nennenswerten Beeinflussung des Durchlaß-, Sperr- und Einschaltverhaltens führt und obendrein noch eine deutliche Reduzierung der Schaltverluste erlaubt.

In einer typischen Weiterbildung der Erfindung grenzen die floatenden Gebiete mindestens teilweise an die Anodenzone an. Dadurch wird gewährleistet, daß der Spannungsdurchbruch direkt am p-n-Übergang zwischen Anodenzone und floatendem Gebiet stattfindet.

Vorteilhafterweise ist die Grenzfläche zwischen der Innenzone und dem floatendem Gebiet ebenfalls gekrümmt. Dies bewirkt ebenfalls eine Störung des elektrischen Feldes und somit in diesen Bereichen eine scharf lokalisierte Feldüberhöhung. Somit ist auch durch diese Maßnahmen das Hochfeld und Niederfeld lokal getrennt.

Da die floatenden Gebiete bezüglich ihrer Leitungseigenschaft wie ein Kurzschluß wirken, können sie in einer Weiterbildung der Erfindung auch durch leitendes Material realisiert werden. Als leitendes Material wird wegen seiner guten Leitfähigkeit und seiner prozesstechnisch einfachen Handhabbarkeit typischerweise sehr hoch dotiertes Polysilizium verwendet. Es sind aber auch andere leitende Materialien wie beispielsweise Metalle oder Metallsilizide denkbar.

Vorteilhafterweise kann anodenseitig oder kathodenseitig eine weitere Zone zur Herstellung eines zweiten p-n-Überganges vorgesehen sein. Diese Zone hat typischerweise eine höhere Dotierungskonzentration als die sich ihr anschließende Anodenzone oder Kathodenzone. Auf diese Weise läßt sich eine Reihenschaltung aus einer geometrisch gekoppelten FCI-Diode und einer zu ihr in Sperrrichtung geschalteten weiteren Diode herstellen. Durch diese monolitisch integrierte, antiparallel angeordnete Diodenreihenschaltung läßt sich der Durchlaßbetrieb der FCI-Diode unterdrücken, so daß sie nun als reiner Spannungsbegrenzer fungiert.

Durch Parallelschaltung einer weiteren Diode läßt sich daraus eine FCI-Hybrid-Dioden-Anordnung gewinnen, bei der im Durchlaßbetrieb nur die weitere Diode und im Sperrbetrieb nur die FCI-Diode relevant ist. Handelt es sich bei der weiteren Diode um ein Bauelement mit optimierten Durchlaßverhalten, so läßt sich auf diese Weise gleichzeitig eine Minimierung der Durchlaß- und der Schaltverluste sowie eine Optimierung des Abkommutierverlaufs erreichen.

Für das bevorzugte Herstellungsverfahren der Bereiche der Anodenzone mit gekrümmten p-n-Übergang sowie der floatenden Gebiete in der Innenzone werden vorteilhafterweise zunächst anodenseitig Gräben in die Oberfläche des Halbleiterkörpers geätzt. Anschließend können nach geeigneter Maskierung der Oberflächen des Halbleiterkörpers die gewünschten Bereiche der Anodenzone bzw. der floatenden Gebiete eingebracht werden. Typischerweise wird dabei die Dotierung durch eine maskierte Diffusion oder Ionenimplantation eingebracht. Anschließend können die Gräben beispielsweise durch CVD wieder aufgefüllt und planarisiert werden.

Besonders vorteilhaft ist es auch, wenn die FCI-Dioden als einfache Read-Dioden ausgebildet sind. Dies ist dann möglich, wenn die Dotierungskonzentration der Kathodenzone sehr hoch gewählt wird. Auf diese Weise läßt sich die Temperaturabhängigkeit der Durchbruchsspannung nahezu kompensieren. Typischerweise weist dabei die Kathodenzone eine Dotierungskonzentration von etwa 10¹⁷ cm 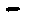 ³ auf. Voraussetzung hierfür ist jedoch eine deutlich höher dotierte Anodenzone.

Geometrisch gekoppelte Leistungsdioden können sehr vorteilhaft als Spannungsbegrenzer zur Unterdrückung transienter Überspannungen verwendet werden. Derzeitig verfügbare transiente Spannungsbegrenzer ( 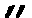 transient-voltage-supressor 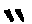 , TVS) sind auf Spannungen ≤ 500 V begrenzt. Andere vergleichbare Bauelemente, wie beispielsweise Varistoren, sprechen nicht schnell genug an, vertragen die mit häufig wiederkehrenden Spannungsspitzen verbundenen Verluste nicht oder altern schneller als erwünscht. Mit den erfindungsgemäßen Dioden lassen sich darüber hinaus auch Spannungsbegrenzter für Spannungen größer als 500 V bereitstellen.

Besonders vorteilhaft lassen sich die erfindungsgemäßen FCI-Dioden auch als Freilaufdioden für Leistungshalbleiterbauelemente verwenden, wie beispielsweise in Parallelschaltung zu Bipolartransistoren, MOSFETS, IGBTs, GTOs, Thyristoren, MCTs, etc.

Der kritischste Betriebszustand einer Leistungsdiode der eingangs genannten Art ist das Abkommutieren, das heißt der Wechsel vom Durchlaß- in den Sperrbetrieb. Beim Abkommutieren muß die im Durchlaßbetrieb zur Leitfähigkeitsmodulation der Innenzone benötigte Speicherladung in sehr kurzer Zeit wieder entfernt werden, um im Anschluß daran wieder Sperrspannung aufnehmen zu können. Dies geschieht über den sogenannten Rückstrom, der sich beim Wechsel in den Sperrbetrieb automatisch einstellt.

Aufgrund des Einflusses unvermeidbarer Streuinduktivitäten kann eine Leistungsdiode jedoch in der Praxis nur mit einer endlichen Steilheit abkommutiert werden. Um dabei hohe induktive Überspannungen sowie Oszillationen zu vermeiden, sollte eine Leistungsdiode ein möglichst weiches Abkommutierverhalten, genannt 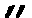 soft-recovery 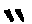 -Verhalten, aufweisen. Darunter versteht man insbesondere einen nach Erreichen der Rückstromspitze sanft abklingenden Rückstrom.

Das Abkommutierverhalten einer Leistungsdiode nach Erreichen der Rückstromspitze ist gekennzeichnet von der Notwendigkeit, die auf den maximalen Rückstrom aufgeladene Streuinduktivität wieder vollständig zu entladen. Um die dabei in der Diode auftretenden Verluste so gering wie möglich zu halten, soll dieser Entladevorgang so schnell wie möglich ablaufen. Gleichzeitig ist aber auch ein Soft-Recovery-Verhalten anzustreben. Das bedeutet eine Begrenzung der auftretenden induktiven Überspannungen sowie die Vermeidung jeglicher Oszillationen, da diese zur Beeinträchtigung bis hin zur Zerstörung benachbarter Bauelemente beziehungsweise der Leistungsdiode selbst führen können.

Eine Begrenzung der Überspannung hat jedoch zwangsläufig eine langsamere Entladung der Streuinduktivität und damit eine Erhöhung der Schaltverluste zur Folge, so daß sich im Zusammenhang mit der Minimierung von Überspannungen und Schaltverlusten grundsätzlich die Frage nach einem Kompromiß stellt. Es besteht allerdings die Möglichkeit, die Schaltverluste im Rahmen dieses Kompromisses bei vorgegebener maximaler Überspannung durch Variation des Strom- bzw. Spannungsverlaufes zu optimieren.

Die Maßnahmen zur Gewährleistung des angestrebten Soft-Recovery-Verhaltens lassen sich je nach Ansatzpunkt in interne und externe Maßnahmen unterscheiden.

Die externen Maßnahmen betreffen entsprechende Modifikationen des umgebenen Netzwerkes der Leistungsdiode oder deren Ansteuerung. Dazu gehört beispielsweise die Beschaltung der Leistungsdiode mit einem sogenannten 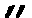 snubber 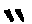 , das heißt einer Reihenschaltung, bestehend aus einem Widerstand und einer Kapazität. Damit soll das Abkommutierverhalten gedämpft werden. Allerdings führt ein snubber immer zu erhöhten Schaltverlusten, einem größeren Volumen und Gewicht des betreffenden Gerätes und schließlich zu höheren Kosten.

Ein anderer Weg, der zur Zeit zur Entlastung von Leistungsdioden und Gewährleistung eines Soft-Recovery-Verhaltens beschritten wird, besteht darin, die Schaltgeschwindigkeiten der beteiligten Halbleiterschalter zu drosseln und so das Abkommutierverhalten zu dämpfen. Dies würde der Einleitung des Abkommutiervorganges durch einen steuerbaren Widerstand an Stelle eines idealen Schalters entsprechen. Auf diese Weise gelingt es zwar, das Auftreten jeglicher Überspannung zu vermeiden und die jeweiligen Leistungsdioden spürbar zu entlasten. Gleichzeitig nehmen jedoch die Schaltverluste der beteiligten Halbleiterschalter stark zu.

Bei den internen Maßnahmen handelt es sich im wesentlichen um entsprechende Eingriffe in das Design von Leistungsdioden. Diese Eigriffe betreffen im wesentlichen die Optimierung des Dotierungsprofils oder der Lebensdauereinstellung.

Das Abkommutierverhalten einer Leistungsdiode bei den beschriebenen externen Maßnahmen wird maßgeblich von anderen Bauelementen bestimmt. Das führt in der Regel immer zu erhöhten Schaltverlusten. Außerdem ist unter diesen Umständen nur noch eine eingeschränkte Optimierung der Leistungsdiode möglich. Aufgrund dessen konzentriert sich die vorliegende Erfindung ausschließlich auf die Optimierung des Diodendesigns.

Üblicherweise wird versucht, ein sanftes Abkommutierverhalten durch Erweiterung der Innenzone und Bereitstellung eines zusätzlichen Ladungsträgerreservoirs, das bereits im Durchlaßbetrieb angelegt wird, zu erreichen. Dies führt jedoch bei den entsprechenden Dioden zu Innenzonenweiten, die gemessen an der zulässigen Sperrspannung überdimensioniert sind. Durch diese Überdimensionierung werden die Durchlaßspannungen beziehungsweise die Schaltverluste erhöht.

Ferner wird bei dieser Vorgehensweise nicht gewährleistet, daß das im Durchlaßbetrieb angelegte Ladungsträgerreservoir auch tatsächlich den Anforderungen des Abkommutiervorganges genügt. Ist das Ladungsträgerreservoir zu klein, so kommt es zum Abriß des Rückstromes und damit durch den Einfluß der Streuinduktivitäten zu erhöhten Überspannungen und durch die Induktivität verursachten, unerwünschten Oszillationen. Ist das Ladungsträgerreservoir dagegen zu groß, so kommt es zu entsprechend langsam abklingenden Rückströmen, den sogenannten 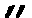 Tail-Strömen 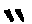 , und damit zu erhöhten Schaltverlusten.

Eine Alternative dazu ist die Begrenzung induktiver Überspannungen während des Abkommutiervorganges durch gezielte Generation von Ladungsträgern und damit durch kontrollierte Entladung der Streuinduktivität, sobald eine bestimmte Sperrspannung überschritten wird. Dieses Konzept wird 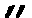 field-controlled-injection 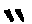 oder kurz FCI genannt. Als Mechanismus zur Erzeugung der erforderlichen Ladungsträger dient dabei die Stoßionisation, die ohnehin das Sperrvermögen einer Leistungsdiode nach oben hin begrenzt.

Durch das FCI-Konzept werden je nach Bedarf Ladungsträger generiert, so daß es automatisch zu einem Soft-Recovery-Verhalten kommt. Voraussetzung ist allerdings eine stark lokalisierte Ladungsträgergeneration, da es sonst zu TRAPATT-Oszillationen kommen kann.

Der grundsätzliche Vorteil des FCI-Konzepts besteht darin, daß keine Überdimensionierung der Innenzone erforderlich ist. Damit lassen sich Durchlaßverluste und Schaltverluste gegenüber den Leistungsdioden der eingangs genannten Art deutlich verringern.

Die Erfindung wird nachfolgend anhand der in den Figuren der Zeichnung angegebenen Ausführungsbeispiele näher erläutert. Es zeigt:
- Figur 1: einen Querschnitt durch den Halbleiterkörper einer pin-Leistungsdiode mit Raumladungskopplung (in der Ausgestaltung einer Read-Diode) nach dem Stand der Technik;
- Figur 2: erstes Ausführungsbeispiel einer geometrisch gekoppelten FCI-Diode;
- Figur 3: zweites Ausführungsbeispiel einer geometrisch gekoppelten FCI-Diode;
- Figur 4: drittes Ausführungsbeispiel einer geometrisch gekoppelten FCI-Diode;
- Figur 5: viertes Ausführungsbeispiel einer geometrisch gekoppelten FCI-Diode;
- Figur 6: einen Querschnitt durch den Halbleiterkörper einer geometrisch gekoppelten FCI-Diode entsprechend Figur 2 mit kathodenseitig integrierter Sperrdiode;
- Figur 7: ein Schaltbild einer FCI-Hybrid-Diode als eine bevorzugte Anwendung einer FCI-Diode mit geometrischer Kopplung.

Figur 2 zeigt den Querschnitt durch den Halbleiterkörper 1 einer erfindungsgemäßen geometrisch gekoppelten FCI-Diode. Gleiche Elemente sind entsprechend Figur 1 mit gleichen Bezugszeichen versehen.

Die Leistungsdiode entsprechend Figur 2 enthält im wesentlichen die Elemente einer pin-Leistungsdiode. Der Halbleiterkörper 1 besteht aus einer n⁻-dotierten Innenzone 2. Kathodenseitig schließt sich an die n⁻-dotierte Innenzone die n⁺-dotierte Kathodenzone 3 an. Die Kathodenzone 3 ist über die Kathodenelektrode 7 mit dem Kathodenanschluß K verbunden. Anodenseitig ist an die n⁻-dotierte Innenzone 2 die p⁺-dotierte Anodenzone 6 angeschlossen. Die Anodenzone 6 ist über die Anodenelektrode 8 mit dem Anodenanschluß A verbunden.

Erfindungsgemäß ist im anodenseitigen Bereich 2' der Innenzone 2 ein zusätzliches Gebiet mit höherer Dotierungskonzentration als in der Innenzone 2 vorgesehen. Dieses zusätzliche Gebiet ist n⁺-dotiert und wird im folgenden als floatendes Gebiet 5 bezeichnet. Im vorliegenden Beispiel ist das floatende Gebiet 5 als vergrabene Schicht ausgebildet.

Das floatende Gebiet 5 weist dabei die Charakteristik eines Kurzschlusses auf und ist in Bezug auf sein Potential floatend. In das floatende Gebiet 5 kann dabei das Hochfeld nicht eindringen. Die Innenzone 2 ist über den p-n-Übergang 4 an die Anodenzone 6 angeschlossen. Die Grenzfläche des p-n-Überganges 4 zwischen Innenzone 2 und Anodenzone 6 ist eben, d. h. sie weist keine Krümmungen auf. Das floatende Gebiet 5 ist dabei nicht mit der Anodenzone 6 verbunden.

Durch die Einbringung des vergrabenen, floatenden Gebietes 5 in die Innenzone 2 wird anodenseitig eine stark inhomogene Dotierungsverteilung erzeugt. Durch diese inhomogene Dotierungsverteilung im anodenseitigen Gebiet der Innenzone 2 kommt es zu einer lokal stark unterschiedlichen Verteilung der Feldlinien des elektrischen Feldes. Insbesondere werden die Feldlinien des elektrischen Feldes bevorzugt in den Bereichen der Grenzfläche des n⁺/n⁻-Überganges 4' zwischen floatendem Gebiet 5 und Innenzone 2 gebündelt, die die stärkste Krümmung aufweisen. An diesem anodenseitigen n⁺/n⁻-Übergang 4' des floatenden Gebietes 5 zur Innenzone 2 kommt es bevorzugt zum Durchbruch. Dies kommt in Figur 2 sowie in den nachfolgenden Figuren durch das Blitz-förmige Symbol zum Ausdruck.

Das floatende Gebiet 5 läßt sich beispielsweise durch Hochenergieionenimplantation als vergrabene Schicht in der Innenzone 2 erzeugen. Alternativ ist es auch denkbar anisotrop einen Graben in die anodenseitige Oberfläche des Halbleiterkörpers 1 zu ätzen. Anschließend wird eine maskierte n⁺-Diffusion zur Erzeugung des floatenden Gebietes 5 durchgeführt.

In Figur 3 ist ein weiteres Ausführungsbeispiel für eine geometrisch gekoppelte FCI-Diode angegeben. Gleiche Elemente sind dabei entsprechend Figur 2 mit gleichen Bezugszeichen versehen.

Die FCI-Diode entsprechend Figur 3 zeigt im wesentlichen die Elemente der FCI-Diode entsprechend Figur 2. Hier ist allerdings die p⁺-dotierte Anodenzone 6 nicht als kontinuierliches, homogenes Gebiet an der Vorderseite des Halbleiterkörpers 1 angeordnet. Vielmehr weist die Grenzfläche des p-n-Überganges 4 zwischen Anodenzone 6 und Innenzone 2 eine Krümmung auf. Des weiteren ist das floatende Gebiet 5 nicht als vergrabene Schicht ausgebildet, sondern grenzt direkt an die Oberfläche des Halbleiterkörpers 1 an. Das n⁺-dotierte floatende Gebiet 5 ist dabei von der Anodenzone 6 beabstandet.

Wie im Beispiel von Figur 2 verursacht das floatende Gebiet 5 auch hier lokal eine unterschiedlichen Verteilung der Dotierungskonzentrationen. Dadurch kommt es ebenfalls zu einer inhomogenen Verteilung der Feldlinien des elektrischen Feldes. Das floatende Gebiet 5 wirkt in Figur 3 ebenfalls als Kurzschluß, wodurch der Durchbruch bevorzugt in dem unmittelbaren Bereich zwischen Anodenzone 6 und floatendem Gebiet 5 stattfindet.

Figur 4 zeigt ein drittes Ausführungsbeispiel der erfindungsgemäßen geometrisch gekoppelten FCI-Diode. Gleiche Elemente sind entsprechend der Figuren 2 und 3 mit gleichen Bezugszeichen versehen.

Figur 4 zeigt eine Weiterentwicklung der geometrisch gekoppelten FCI-Diode entsprechend Figur 3. Hierbei ist das n⁺-dotierte floatende Gebiet 5 nicht mehr von der Anodenzone 6 beabstandet. Vielmehr grenzt das floatende Gebiet 5 teilweise an die Anodenzone 6 an. Es kommt daher bevorzugt am p-n-Übergang 4 zwischen floatendem Gebiet 5 und Anodenzone 6 zum Durchbruch. Des weiteren weist die FCI-Diode entsprechend Figur 4 in der Anodenzone 6 einen Graben 9 auf. An der Oberfläche des Grabens ist die Anodenelektrode 8 angeordnet.

Der Graben 9 in Figur 4 ist insbesondere bei der Herstellung der erfindungsgemäßen Strukturen von Vorteil. Dabei wird nach dem anisotropen Ätzen des Grabens 9 die Anodenzone 6 durch maskierte Diffusion erzeugt. Die Oberfläche des Grabens wird anschließend großflächig mit einer üblichen Metallisierung bedeckt. Die Metallisierung bildet dann die Anodenelektrode 8.

In den Figuren 2 bis 4 sind die floatenden Gebiete 5 sehr viel höher dotiert als die Innenzone 2. Typischerweise weisen die floatende Gebiet 5 eine Dotierungskonzentration mindestens von 10¹⁶ cm 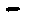 ³ auf. Die Innenzone 2 weist hingegen eine Dotierungskonzentration von mindestens 10¹⁵ cm 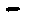 ³ auf.

Da die floatenden Gebiete 5 eine sehr hohe Dotierungskonzentration aufweisen, wirken sie bezüglich ihrer Potentiale als Kurzschluß. Aufgrund dessen ist es auch denkbar, die floatenden Gebiete 5 statt mit sehr hoch dotiertem Silizium auch mit einem anderen gut leitendem Material, beispielsweise Polysilizium, Metallsilizid oder Metall, zu ersetzen.

In den Figuren 2 bis 4 ist beispielhaft nur jeweils ein floatendes Gebiet 5 dargestellt. Selbstverständlich können auch mehrere floatende Gebiete 5 in dem Leistungshalbleiterbauelement vorgesehen sein.

Figur 5 zeigt ein viertes Ausführungsbeispiel der erfindungsgemäßen geometrisch gekoppelten FCI-Diode. Gleiche Elemente sind entsprechend der vorhergehenden Figuren mit gleichen Bezugszeichen versehen.

Figur 5 zeigt eine geometrisch gekoppelten FCI-Diode, die im Gegensatz zu den Figuren 2 bis 4 über kein floatendes Gebiet 5 verfügt. Die Funktion des floatenden Gebietes 5 wird hier durch die Ausgestaltung der Anodenzone 6 ersetzt. Die Anodenzone 6 weist hier zapfenartig in den Halbleiterkörper 1 hineinragende Gebiete auf. Durch diese zapfenartig in den Halbleiterkörper 1 hineinragenden Gebiete wird eine starke Krümmung der Grenzfläche des p-n-Überganges 4 zwischen Anodenzone 6 und Innenzone 2 erzeugt. Diese Krümmung bewirkt ähnlich wie in den Beispielen aus den Figuren 2 bis 4 eine lokale Trennung von Hochfeldzone und Niederfeldzone. Ein Durchbruch des elektrischen Feldes findet hier bevorzugt in den Bereichen der stärksten Krümmung des p-n-Überganges statt. Typischerweise ist das an der Spitze der zapfenartigen Gebiete der Anodenzone 6.

Ähnlich wie in Figur 4 sind in Figur 5 Gräben 9 vorgesehen, die herstellungstechnisch von besonderem Vorteil sind. Durch den Graben 9 lassen sich insbesondere die zapfenartigen Bereiche der Anodenzone 6 auf einfache Weise herstellen. Dabei wird ähnlich wie im Beispiel von Figur 4 zunächst der Graben 9 anisotrop geätzt. Anschließend können die zapfenartigen Bereiche der Anodenzone beispielsweise durch eine unmaskierte Diffusion erzeugt werden.

Figur 6 zeigt eine entsprechend Figur 2 weitergebildete geometrisch gekoppelte FCI-Diode. Gleiche Elemente sind entsprechend der vorhergehenden Figuren mit gleichen Bezugszeichen versehen.

Die FCI-Diode entsprechend Figur 2 wurde in Figur 6 derart weitergebildet, daß kathodenseitig eine weitere p 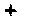 -dotierte Zone 10 zwischen Kathodenelektrode 7 und Kathodenzone 3 vorgesehen ist. Durch das Hinzufügen einer zusätzlichen Zone 10 in den Halbleiterkörper 1 aus Figur 2 wird ein zusätzlicher p-n-Übergang 12 erzeugt. Auf diese Weise läßt sich ein monolithisch integriertes Halbleiterbauelement bestehend aus zwei antiparallelen und in Reihe geschalteten Dioden herstellen.

Grundsätzlich ist bei Erzeugung eines zusätzlichen p-n-Überganges 12 durch Einfügung einer zusätzlichen Zone 10 in die FCI-Diode entsprechend Figur 2 darauf zu achten, daß die Diode des betreffenden neu erzeugten p-n-Überganges 12 antiparallel und in Reihe zu der FCI-Diode geschaltet ist. Darüberhinaus ist zu beachten, daß die Durchbruchspannung des zusätzlichen p-n-Überganges 12 ausreichend hoch dimensioniert ist, um einen Stromfluß in Durchlaßrichtung zu verhindern. Aus diesem Grund ist im vorliegenden Beispiel die Kathodenzone 3 niedriger dotiert als die weitere Zone 10. Schließlich ist darauf zu achten, daß die an die weitere Zone 10 angrenzende Kathodenzone 3 weit genug dimensioniert ist, so daß es nicht zum 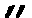 punch-through 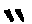 der Kathodenzone 3 kommt. In diesem Fall würde die sperrende Wirkung des p-n-Überganges 4 außer Kraft gesetzt werden.

Es ist selbstverständlich auch denkbar, die zusätzliche Zone 10 anodenseitig zwischen der Anodenzone 6 und der Anodenelektrode 8 anzuordnen. Die anodenseitige zusätzliche Zone müßte in diesem Fall n 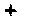 -dotiert sein und die Anodenzone 6 müßte ausreichend weit dimensioniert sein.

Ein zusätzlicher p-n-Übergang zur Realisierung von zwei antiparallel geschalteten Dioden läßt sich selbstverständlich auch durch einen anodenseitigen oder kathodenseitigen Schottky-Kontakt anstelle einer weiteren Zone 10 erzeugen.

Figur 7 zeigt ein Schaltbild einer FCI-Hybrid-Diode als eine vorteilhafte Anwendung der FCI-Diode entsprechend der Figuren 2 bis 5. Zwischen einem Anodenanschluß A und einem Kathodenanschluß K befindet sich die Parallelschaltung aus der Diode D₂ und der Diode D_{FCI}. Die Diode D₂ ist dabei beispielsweise eine auf gutes Durchlaßverhalten optimierte Leistungsdiode. Die FCI-Diode D_{FCI} hat die Funktion eines Spannungsbegrenzers und ist nur im Sperrbetrieb wirksam. Im Durchlaßbetrieb ist die Diode D_{FCI} durch die in Reihe und antiparallel dazu geschaltete Diode D₁ gesperrt. Somit ist im Durchlaßbetrieb die Diode D₂ und im Sperrbetrieb die Diode D_{FCI} relevant.

Die Dioden D₁, D₂ und D_{FCI} lassen sich als monolitisch integriertes Halbleiterbauelement realisieren. Es ist allerdings auch eine diskrete Realisierung der Bauelemente denkbar. Die Vorteile einer monolitisch integrierten Anordnung liegen in einem induktivitätsarmen Aufbau, der insbesondere die Reduktion der Schaltverluste erlaubt.

Besonders vorteilhaft ist die Anwendung von FCI-Dioden als Freilaufdioden oder Spannungsbegrenzer in Parallelschaltung zu abschaltbaren Leistungshalbleiterbauelementen, wie beispielsweise Bipolartransistoren, MOSFETS, IGBTs, GTOs, Thyristoren, MCTs, etc. Dabei ist sowohl eine monolithische Integration als auch ein hybrider oder diskreter Aufbau denkbar.

Ein besonderer Vorteil der Erfindung ist schließlich, daß die erfindungsgemäßen FCI-Dioden auch als einfache Dioden mit Read-Struktur ausgeführt sein können. Dies war bislang nicht möglich, da derartige Read-Dioden eine sehr starke Temperaturabhängigkeit ihrer Durchbruchsspannung aufweisen. Die Ursache für die starke Temperaturabhängigkeit der Durchbruchspannung liegt in der Temperaturabhängigkeit der Stoßionisation, die im Spannungsdurchbruch innerhalb der Hochfeldzone auftritt und sich aufgrund der konstanten Raumladung dieser Hochfeldzone besonders stark auf die Feldstärke der angrenzenden, deutlich breiter dimensionierten Niederfeldzone und somit auf die Durchbruchsspannung der Diode auswirkt. Um dieses Problem der Raumladungskopplung zu umgehen, wurden bislang äußerst komplizierte Strukturen vorgeschlagen, bei denen die Feldstärken der Hochfeldzonen und Niederfeldzonen nicht über eine konstante Raumladung, sondern über die Ausnutzung des "punch-through"-Effektes bzw. durch Geometrieeffekte wie oben beschrieben gekoppelt wurden.

Erfindungsgemäß lassen sich FCI-Dioden mit Read-Struktur über die Dotierungskonzentration in der n 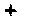 -dotierten Kathodenzone 3 realisieren. Über die Höhe der Dotierungskonzentration der Kathodenzone 3 ist es somit möglich, ähnlich wie bei Kleinleistungsdioden den Tunnel-Effekt am p-n-Übergang zwischen der p-dotierten Anodenzone 6 und der n-dotierten Kathodenzone 3 zu begünstigen.

Da der Tunnel-Effekt über einen der Stoßionisation entgegengesetzten Temperaturkoeffizienten verfügt, kann über die Höhe der Dotierungskonzentration in der Kathodenzone 3 der Temperaturkoeffizient der Durchbruchspannung der als Read-Diode aufgeführten FCI-Diode nahezu beliebig eingestellt werden. Es ist somit zu erwarten, daß sich beispielsweise bei einer Dotierungskonzentration der Kathodenzone 3 von etwa 10¹⁷ cm 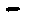 ³ eine Durchbruchsspannung der als Read-Diode ausgeführten FCI-Diode mit schwach positiven Temperaturkoeffizienten einstellen läßt. Damit kann eine Stromfilamentierung vermieden werden und ein sicherer Betrieb gewährleistet werden. Voraussetzung hierfür ist jedoch eine gegenüber der Kathodenzone 3 deutlich höher dotierte Anodenzone 6.

Durch die Erfindung ist es somit auf technologisch sehr einfache Weise möglich, eine FCI-Diode in der sehr einfachen Struktur einer Read-Diode auszuführen. Die Temperaturabhängigkeit der Durchbruchsspannung läßt sich dabei beliebig einstellen und demzufolge auch kompensieren.

## Patentansprüche

1. Leistungsdiode bestehend aus einem Halbleiterkörper (1) mit
- einer Innenzone (2) vom ersten Leitungstyp,
- einer an die Innenzone (2) anschließenden Kathodenzone (3) vom ersten Leitungstyp und höherer Dotierungskonzentration als in der Innenzone (2),
- einer an die Innenzone (2) anschließenden Anodezone (6) vom zweiten Leitungstyp und höhere Dotierungskonzentration als in der Innenzone (2)
**dadurch gekennzeichnet,** daß
die Grenzfläche (4) zwischen der Innenzone (2) und der Anodenzone (6) zumindest teilweise gekrümmt ist und/oder in der Innenzone (2) zumindest ein floatendes Gebiet (5) vom ersten Leitungstyp vorgesehen ist.

2. Leistungsdiode nach Anspruch 1,
**dadurch gekennzeichnet,** daß
die Dotierungskonzentration in den floatenden Gebieten (5) höhere ist als die der Innenzone (2).

3. Leistungsdiode nach einem der Ansprüche 1 oder 2,
**dadurch gekennzeichnet,** daß
die floatenden Gebiete (5) sich in dem anodenseitigen Gebiet (2') der Innenzone (2) befinden.

4. Leistungsdiode nach einem der Ansprüche 1 oder 3,
**dadurch gekennzeichnet,** daß
die floatenden Gebiete (5) mindestens teilweise an die Anodenzone (6) angrenzen.

5. Leistungsdiode nach einem der Ansprüche 1 oder 4,
**dadurch gekennzeichnet,** daß
eine weitere Grenzfläche (4') zwischen der Innenzone (2) und dem floatenden Gebiet (5) zumindest teilweise gekrümmt ist.

6. Leistungsdiode nach einem der Ansprüche 1 bis 5, **dadurch gekennzeichnet,** daß
die floatenden Gebiete (5) aus leitendem Material bestehen.

7. Leistungsdiode nach Anspruch 6,
**dadurch gekennzeichnet,** daß
die floatenden Gebiete (5) mindestens teilweise aus hochdotiertem Polysilizium bestehen.

8. Leistungsdiode nach einem der Ansprüche 1 bis 7,
**dadurch gekennzeichnet,** daß
im Halbleiterkörper (1) zumindest eine zur Leistungsdiode antiparallel und in Reihe geschaltete zweite, monolithisch integrierte Diode vorgesehen ist.

9. Leistungsdiode nach einem der vorhergehenden Ansprüche mit einer Read-Diodenstruktur.

10. Verfahren zur Herstellung von Leistungsdioden nach einem der Ansprüche 1 bis 9,
**dadurch gekennzeichnet,** daß
Gräben (9) anodenseitig in den Halbleiterkörper (1) geätzt werden und anschließend die floatenden Gebiete (5) und/oder die Bereiche der Anodenzone (6) mit gekrümmter Grenzfläche (4) durch Diffusion und/oder Ionenimplantation eingebracht werden.

11. Hybrid-Dioden-Anordnung mit einer Leistungsdiode nach einem der vorherigen Ansprüche.

12. Spannungsbegrenzer mit einer Leistungsdiode nach einem der vorherigen Ansprüche.

13. Freilaufdiode mit einer Leistungsdiode nach einem der Ansprüche 1 - 11.

14. Leistungsdiode nach einem der vorherigen Ansprüche in Parallelschaltung zu einem Leistungshalbleiterbauelement.
